(19) **Europäisches Patentamt / European Patent Office / Office européen des brevets**

(11) **EP 1 988 628 A1**

(12) # EUROPEAN PATENT APPLICATION

(43) Date of publication:
**05.11.2008 Bulletin 2008/45**

(51) Int Cl.:
*H03B 5/12* (2006.01)

(21) Application number: **07115764.8**

(22) Date of filing: **05.09.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **04.05.2007 US 800403**

(71) Applicant: **MediaTek Inc.**
**1st Science-Based Industrial Park**
**Hsin-Chu 300 (TW)**

(72) Inventors:
- **Lin, Tser-Yu**
  **Hsinchu City 300 (TW)**
- **Ke, Ling-Wei**
  **Jhudong Township, Hsinchu County 310, (TW)**
- **Yu, Tai-Yuan**
  **Taoyuan County 320, (TW)**

(74) Representative: **2K Patentanwälte Kewitz & Kollegen**
**Partnerschaft**
**Corneliusstrasse 18**
**60325 Frankfurt am Main (DE)**

(54) **LC voltage controlled oscillator with tunable capacitance unit**

(57) A tunable capacitance unit (300) coupled between a pair of circuit nodes. The tunable capacitance unit (300) comprises a tuning input (301) supplying a tuning voltage (Vtune), and first and second tuning capacitance units (330, 340). Each of the tuning capacitance units comprises a pair of accumulation-mode MOS varactors (CV1, CV2; CV3, CV4) with source/drains thereof coupled to the tuning input (301), a pair of blocking capacitors (C1, C2; C3, C4) coupled to a respective gate of the accumulation-mode MOS varactors and to a respective one of the circuit nodes, and a pair of biasing resistors (R1, R2; R3, R4) coupled to a respective gate of the accumulation-mode MOS varactors and to a respective bias terminal receiving a respective reference voltage (Vref1, Vref2). The reference voltages received by the first and second tuning capacitance units (330, 340) are symmetrical to a predetermined voltage.

FIG. 4

EP 1 988 628 A1

**Description**

BACKGROUND OF THE INVENTION

**Field of the Invention**

The invention relates to a voltage controlled oscillator (VCO) and, in particular, to an LC VCO with a tunable capacitance unit.

**Description of the Related Art**

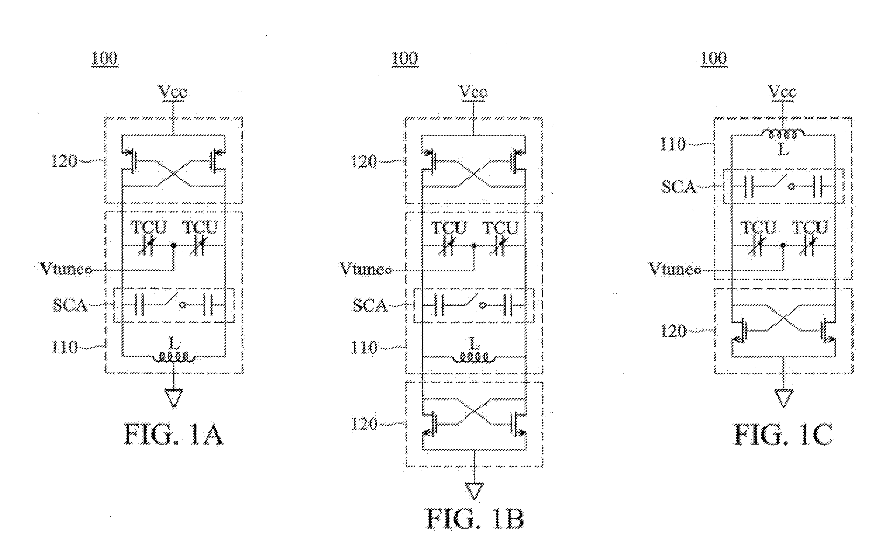

Figs 1A, 1B and 1C are respectively a circuit diagram of a LC tank voltage controlled oscillator (VCO) 100, or an LC VCO. The LC VCO 100 typically comprises an LC tank circuit 110 and a negative resistance circuit 120. The LC tank circuit 110 comprises an inductor L and a tunable capacitance unit TCU. A capacitance of the tunable capacitance unit TCU is typically tuned by a tuning voltage Vtune. The negative resistance circuit 120 comprises a pair of MOS transistors, each having a gate, a source and a drain. The gates of the MOS transistors are cross-coupled to the drains thereof and sources thereof are coupled to a fixed voltage, Vcc or ground. In addition, the LC tank circuit 110 further comprises a switch capacitor array SCA such that the LC VCO 100 becomes a wide band LC VCO with a wide operating frequency range. The tunable capacitance unit TCU is typically used to tune an oscillating frequency of the LC VCO 100 if the switch capacitor array SCA is fixed to a single sub-band. When the tuning voltage Vtune goes high or low, the capacitance of the tunable capacitance unit TCU changes and results in frequency change of the LC VCO 100.

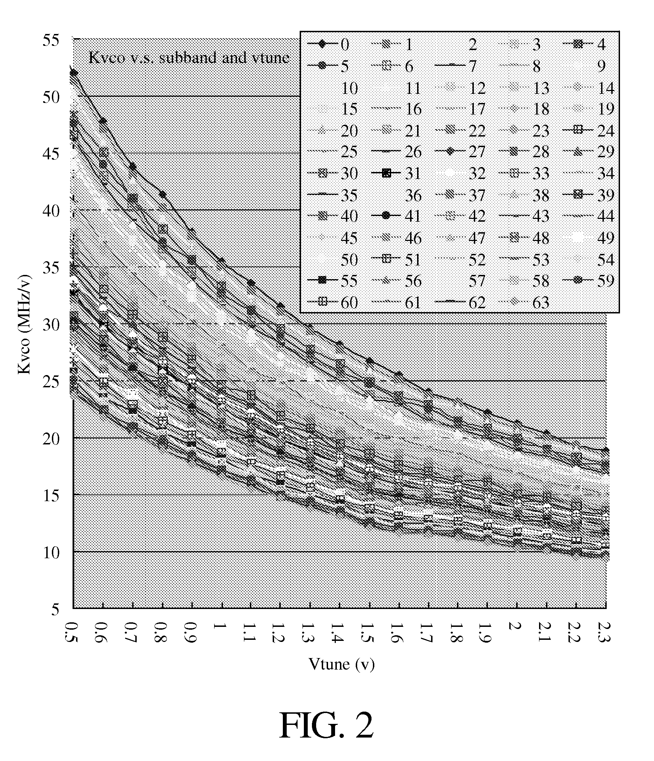

Fig. 2 shows a typical characteristic of a gain of the LC VCO shown in Fig. 1A, 1B or 1C versus a tuning voltage thereof within different sub-bands. A gain Kvco of the LC VCO is defined as a change in an oscillating frequency thereof divided by a change in a tuning voltage thereof, i.e. $\dfrac{f_1 - f_2}{V_{tune1} - V_{tune2}}$ , wherein $f_1$ ($f_2$)is an oscillating frequency of the LC VCO when the tuning voltage thereof is $V_{tune1}$ ($V_{tune2}$). Since an oscillating frequency f of the LC VCO follows the formula $f = \dfrac{1}{2\pi\sqrt{L \cdot (C_{parasitic} + C_{SCA} + C_{TCU})}}$ , wherein L is an inductance of the inductor, $C_{SCA}$ is a capacitance of the switch capacitor array SCA, and $C_{TCU}$ is a capacitance of the tunable capacitance unit TCU, the curves in Fig. 2 are not linear and not desirable to circuit designers.

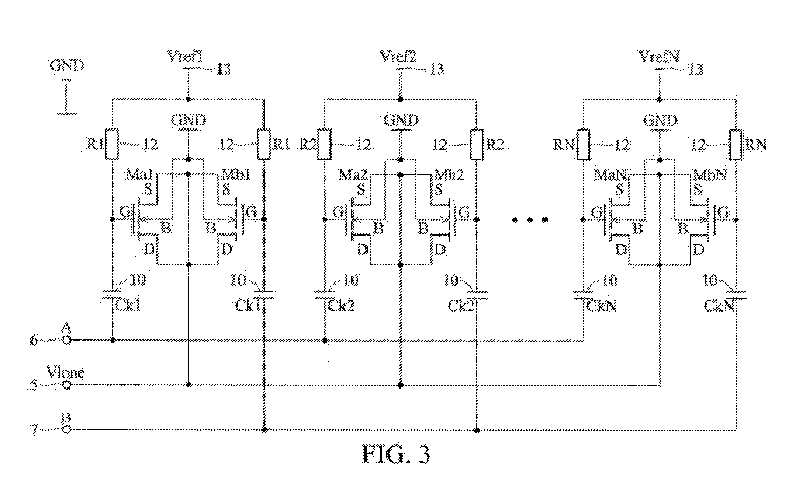

Fig. 3 is a circuit diagram of a conventional tunable capacitive component as disclosed in US patent 6,995,626. The tunable capacitive component comprises a pair of MOS transistors Ma1/Mb1 (Ma2/Mb2,..., MaN/MbN) gate connections of which are connected via a respective coupling capacitance 10 to a pair of circuit nodes 6/7 between which the tuned capacitance can be tapped off. The four load connections of the MOS transistors Ma1/Mb1 (Ma2/Mb2,..., MaN/MbN) are connected to one another. A tuning input 5 is coupled to the transistor pair Ma1/Mb1 (Ma2/Mb2,..., MaN/MbN) such that a tuning voltage is provided thereto. In addition, the gate connections of the pair of MOS transistors Ma1/Mb1 (Ma2/Mb2,..., MaN/MbN) are coupled to a reference signal input Vref1 (Vref12,..., Vref1N) via resistors R1 (R 2,..., R N). In this arrangement, the reference signal input is designed to set the operating point of the transistors. The tunable capacitance has a wide tuning range and also a low series resistance and permits good linearity properties on account of the operating point setting. However, such arrangement cannot provide a tunable Kvco according to an oscillating frequency of an LC oscillator.

BRIEF SUMMARY OF THE INVENTION

An embodiment of tunable capacitance unit coupled between a pair of circuit nodes comprises a tuning input supplying a tuning voltage, and first and second tuning capacitance units. Each of the tuning capacitance units comprises a pair of accumulation-mode MOS varactors with source/drains thereof coupled to the tuning input, a pair of blocking capacitors coupled to a respective gate of the accumulation-mode MOS varactors and to a respective one of the circuit nodes, and a pair of biasing resistors coupled to a respective gate of the accumulation-mode MOS varactors and to a respective bias terminal receiving a respective reference voltage. The reference voltages received by the first and second tuning capacitance units are symmetrical to a predetermined voltage.
An embodiment of a LC voltage controlled oscillator comprises a LC tank circuit and a negative resistance circuit coupled to the LC tank circuit. The LC tank circuit comprises an inductor and the disclosed tunable capacitance unit.
A LC voltage controlled oscillator (VCO) with a tunable capacitance unit is disclosed. The disclosed LC VCO has a constant gain ($K_{VCO}$) within a wide frequency band and a bandwidth of a phase locked loop (PLL) circuit can be tuned by tuning a gain Kvco of the LC VCO. In addition, requirements for a compensation current of a charge pump circuit in the PLL circuit are relaxed and degradation of out-of-band phase noise due to high $K_{VCO}$ can also be avoided.

A detailed description is given in the following embodiments with reference to the accompanying drawings.

BRIEF DESCRIPTION OF THE DRAWINGS

The invention can be more fully understood by reading the subsequent detailed description and examples with references made to the accompanying drawings, wherein:

Figs 1A, 1B and 1C are respectively a circuit diagram of a LC tank voltage controlled oscillator (VCO) 100, or an LC VCO;

Fig. 2 shows a typical characteristic of a gain of the LC VCO shown in Fig. 1A, 1B or 1C versus a tuning voltage thereof within different sub-bands;

Fig. 3 is a circuit diagram of a conventional tunable capacitive component disclosed in US patent 6,995,626;

Fig. 4 is a circuit diagram of a tunable capacitance unit according to an embodiment of the invention;

Figs. 5A, 5B, and 5C are respectively schematic diagrams of a symbol, a schematic, and a cross section of the tunable capacitance unit in Fig. 4;

Fig. 6 is a diagram showing an equivalent capacitance versus a tuning voltage Vtune of the tunable capacitance unit in Fig. 4;

Fig. 7A is a circuit diagram showing an expansive variant of the tunable capacitance unit in Fig. 4;

Fig. 7B is a diagram showing an equivalent capacitance versus a tuning voltage of the tunable capacitance unit in Fig. 7A;

Fig 8 is a circuit diagram showing an expansive variant of the tunable capacitance unit under process corner conditions in Fig. 4;

Fig. 9 is a diagram showing simulated results of $K_{TCU}$ versus $\Delta V$ of the tunable capacitance unit in Fig. 4;

Fig. 10 is a diagram showing simulated results of $K_{TCU}$ versus a tuning voltage of the tunable capacitance unit in Fig. 4 under different $\Delta V$ values; and

Fig. 11 is a diagram showing simulated results of an equivalent capacitance versus $\Delta V$ of the tunable capacitance unit in Fig. 4 for different process corners when the tuning voltage Vtune is 0.7V;

Fig. 12A is a diagram showing simulated results of $K_{TCU}$ versus a tuning voltage Vtune of the tunable capacitance unit in Fig. 4 at different temperatures (-20°C and 85°C); and

Fig. 12B is a diagram showing simulated results of $K_{TCU}$ versus a tuning voltage Vtune of the tunable capacitance unit at different temperatures (-20°C, room temperature, and 85°C).

DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

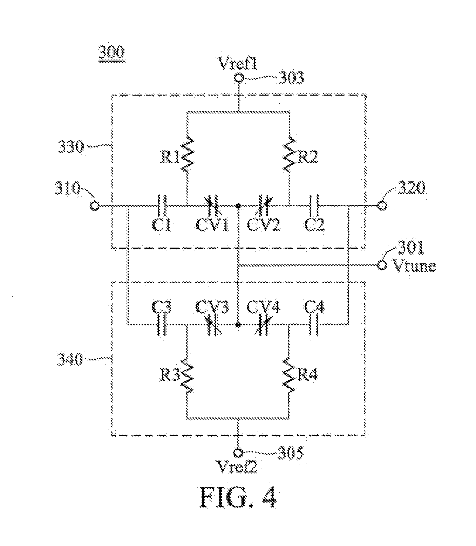

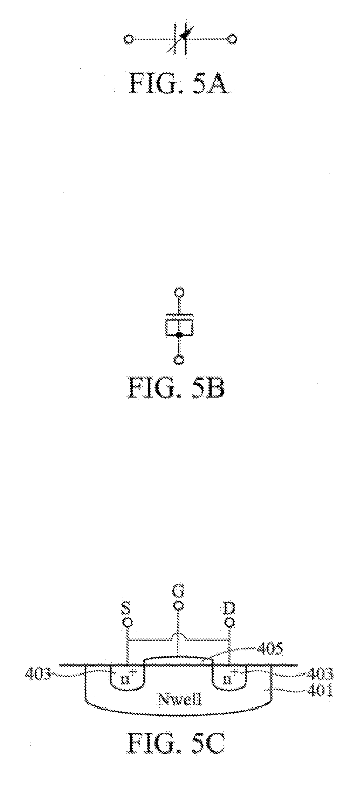

Fig. 4 is a circuit diagram of a tunable capacitance unit according to an embodiment of the invention. The tunable capacitance unit 300 comprises a tuning input 301 and first and second tuning capacitance units 330 and 340. The first tuning capacitance comprises a first pair of accumulation-mode MOS varactors CV1/CV2, a first pair of blocking capacitors C1/C2, and a first pair of biasing resistors R1/R2. The second tuning capacitance comprises a second pair of accumulation-mode MOS varactors CV3/CV4, a second pair of blocking capacitors C3/C4, and a second pair of biasing resistors R3/R4. A symbol, a schematic and a cross section of the accumulation-mode MOS varactors CV1/CV2 and CV3/CV4 in Fig. 4 are respectively shown in Fig. 5A, Fig 5B, and Fig. 5C. As shown in Fig. 5C, each of the accumulation-mode MOS varactors CV1/CV2 and CV3/CV4 has a N-well 401, source/drain regions 403, a gate dielectric (not shown in the figure), and a gate 405 over the gate dielectric. In Fig. 4, the tuning input 301 receives a tuning voltage Vtune. The first pair of accumulation-mode MOS varactors CV1/CV2 is coupled between the tuning input 301 and the first pair of blocking capacitors C1/C2 and biasing resistors R1/R2. More specifically, source/drains of the first pair of accumulation-mode MOS varactors CV1/CV2 are coupled to the tuning input 301. The first pair of blocking capacitors C1/C2 is coupled to a respective gate of the first pair of the accumulation-mode MOS varactors CV1/CV2 and to a respective one of the circuit nodes 310/320. The first pair of biasing resistors R1/R2 is coupled to a respective gate of the first pair of the accumulation-mode MOS varactors CV1/CV2 and to a first bias terminal 303 receiving a first reference voltage Vref1. Similarly, the second pair of accumulation-mode MOS varactors CV3/CV4 is coupled between the tuning input 301 and the second pair of blocking capacitors C3/C4 and biasing resistors R3/R4. More specifically, source/drains of the second pair of accumulation-mode MOS varactors CV3/CV4 are coupled to the tuning input 301. The second pair of blocking capacitors C3/C4 is coupled to a respective gate of the second pair of the accumulation-mode MOS varactors

CV3/CV4 and to a respective one of the circuit nodes 310/320. The second pair of biasing resistors R1/R2 is coupled to a respective gate of the second pair of the accumulation-mode MOS varactors CV3/CV4 and to a second bias terminal 305 receiving a second reference voltage Vref2. The first reference voltage Vref1 and the second reference voltage Vref2 are symmetrical to a predetermined voltage Vnom. In other words, the first and second reference voltages Vref1 and Vref2 can be expressed as Vnom+$\Delta$V and Vnom-$\Delta$V.

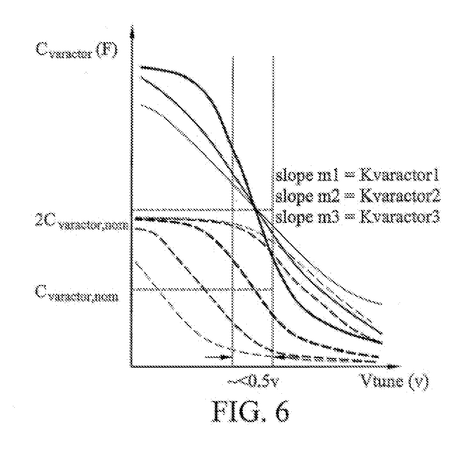

The tunable capacitance unit TCU in Fig. 1A, 1B or 1C can be replaced by that in Fig. 3. Thus, the first and second reference voltages can be biased such that different $K_{VCO}$ is obtained. An exemplary bias table is shown in Table I. Fig. 6 is a diagram showing an equivalent capacitance versus a tuning voltage Vtune of the tunable capacitance unit in Fig. 4. When the first and second reference voltages are biased at bias condition 1, 2, and 3, the tunable capacitance unit has different $K_{TCU}$ m1, m2, and m3, wherein $K_{TCU} = \dfrac{\Delta C_{TCU}}{\Delta V_{tune}}$. It is known that $K_{TCU}$ is proportional to $K_{VCO}$ within a small tuning voltage range. As a result, different $K_{TCU}$ of the tunable capacitance unit results in different Kvco of the LC VCO having the same. In addition, due to the symmetrical bias conditions, the equivalent capacitance $C_{TCU}$ of the tunable capacitance unit is fixed when tuning $K_{TCU}$ thereof. Accordingly, center operating frequency of the LC VCO is fixed after the switch capacitor array is calibrated irrespective of the value of value $K_{TCU}$.

Table I

| Bias condition | Vref1(V) | Vref2(V) | $K_{TCU}$ |
|---|---|---|---|
| 1 | Vnom | Vnom | m1 |
| 2 | Vnom+$\Delta$V1 | Vnom-$\Delta$V1 | m2 |
| 3 | Vnom+$\Delta$V2 | Vnom-$\Delta$V2 | m3 |

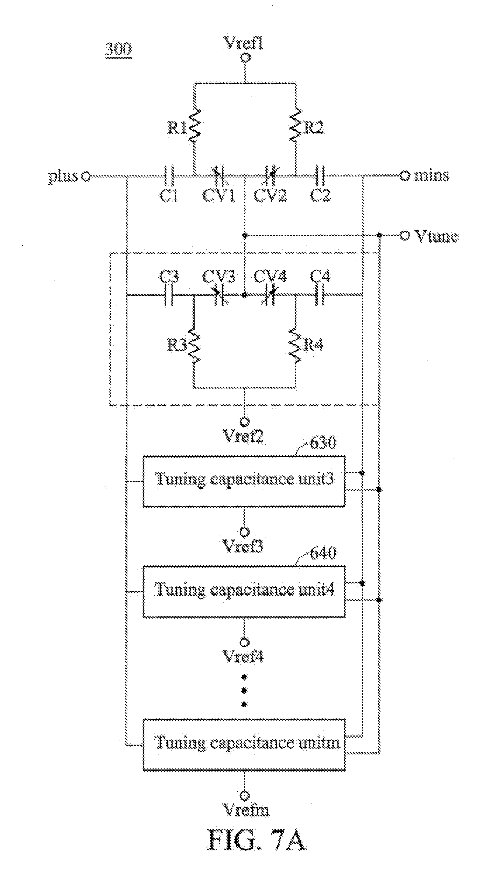

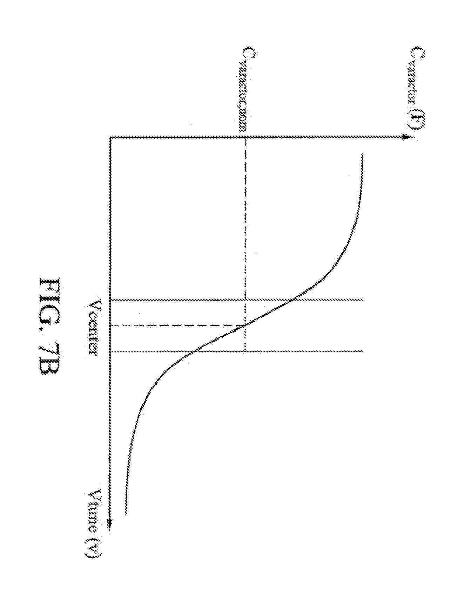

Fig. 7A is a circuit diagram showing an expansive variant of the tunable capacitance unit in Fig. 4. In addition to the first and second tuning capacitance units, the tunable capacitance unit further comprises a third tuning capacitance unit 630 and a fourth tuning capacitance unit 640. As with the tuning capacitance units in Fig. 4, the third tuning capacitance unit 630 comprises a third pair of accumulation-mode MOS varactors with source/drains thereof coupled to the tuning input, a third pair of blocking capacitors coupled to a respective gate of the third pair of accumulation-mode MOS varactors and to a respective one of the circuit nodes, a third pair of biasing resistors coupled to a respective gate of the third pair of accumulation-mode MOS varactors and to a third bias terminal receiving a third reference voltage. The fourth tuning capacitance unit 640 comprises a fourth pair of accumulation-mode MOS varactors with source/drains thereof coupled to the tuning input, a fourth pair of blocking capacitors coupled to a respective gate of the third pair of accumulation-mode MOS varactors and to a respective one of the circuit nodes, and a fourth pair of biasing resistors coupled to a respective gate of the fourth pair of accumulation-mode MOS varactors and to a fourth bias terminal receiving a fourth reference voltage, wherein the third and fourth reference voltages are symmetrical to the predetermined voltage. In addition, the tunable capacitance unit can comprise more tuning capacitance units. To keep the equivalent capacitance $C_{TCU}$ of the tunable capacitance unit fixed when tuning $K_{TCU}$ thereof, the reference voltages received by the tunable capacitance unit have the following relationship: $Vcenter = \dfrac{Vrefn + Vref(m-n+1)}{2}$, wherein Vcenter is a tuning voltage at which the tunable capacitance unit has a linear change in $C_{TCU}$ with respect to the tuning voltage Vtune, as shown in Fig. 7B.

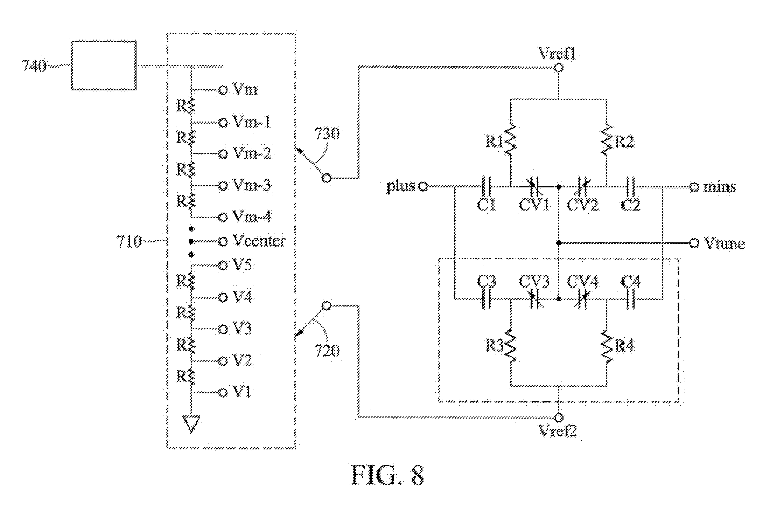

Fig 8 is circuit diagram showing an expansive variant of the tunable capacitance unit in Fig. 4. The tunable capacitance unit 700 in Fig. 8 comprises the disclosed components as shown in Fig. 4. In addition, the tunable capacitance unit 700 further comprises a voltage divider 710 and first and second multiplexors 720 and 730. The voltage divider 710 comprises a plurality of resistors R connected in series between a pair of fixed voltages and provides a plurality of reference voltages V1, V2, ..., Vm-1, and Vm. Each of the first and second multiplexors 720 and 730 is coupled between a respective one of the bias terminals 303 (or 305) and the voltage divider 710. The predetermined voltage Vnom is here a center voltage Vcenter of the voltage divider 710 and the first and second reference voltages Vref1 and Vref2 are selected from the reference voltages V1, V2, ..., Vm-1, and Vm. In addition, the tunable capacitance unit 700 further comprises a temperature compensation circuit 740. The temperature compensation circuit provides at least one of the fixed voltages such that characteristic variation of the tunable capacitance unit due to temperature variation is compensated.

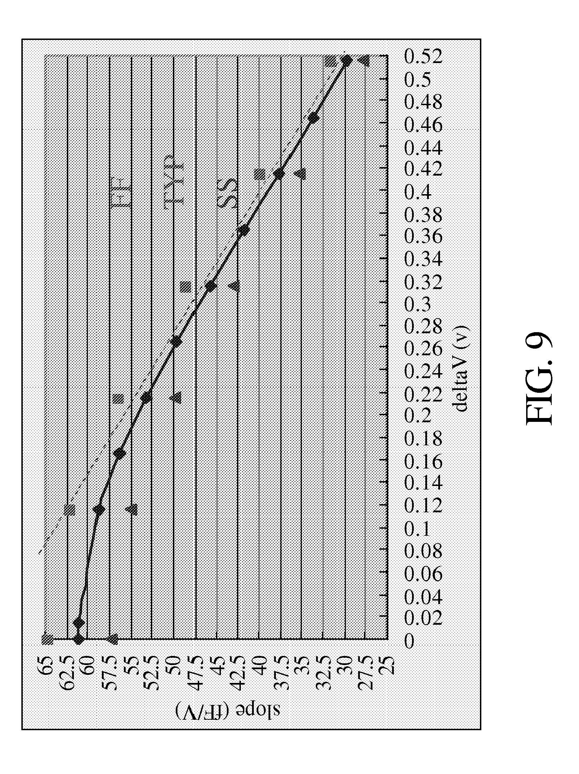

Fig. 9 is a diagram showing simulation results of $K_{TCU}$ versus $\Delta V$ of the tunable capacitance unit in Fig. 3. In Fig. 9, square data points are data points of a process corner with fast NMOS and PMOS devices, diamond data points represent those of a process corner with typical NMOS and PMOS devices, and triangle data points represent those of a process corner with slow NMOS and PMOS devices. It is found that $K_{TCU}$ has a linear change with respect to $\Delta V$ from $\Delta V=0.26V$ to $\Delta V=0.47V$ and is thus more easily controlled. In addition, in such a linear region, center operating frequency of the LC VCO does not vary with a different bias reference voltage significantly, which is also desirable to circuit designers. Since different process corners does not result in significant change in $K_{TCU}$, characteristics of the LC VCO are not significantly influenced by process variation.

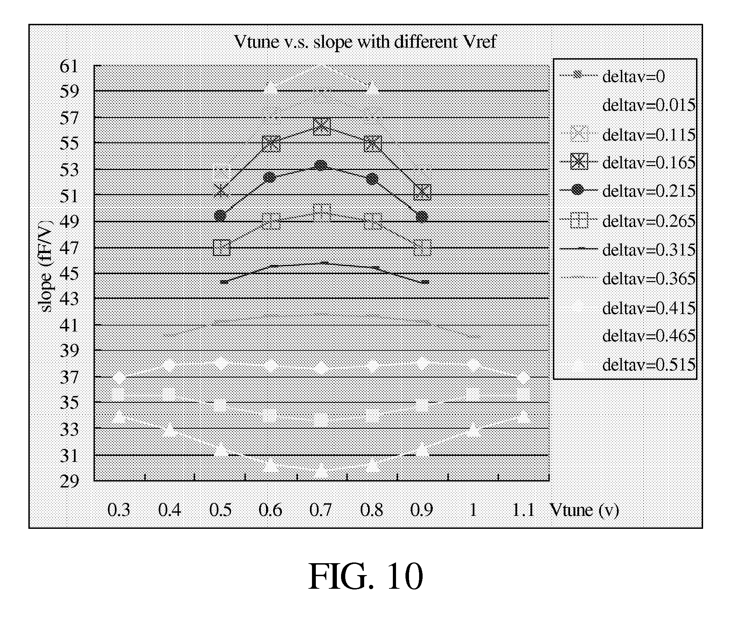

Fig. 10 is a diagram showing simulation results of $K_{TCU}$ versus a tuning voltage Vtune of the tunable capacitance unit in Fig. 3 under different $\Delta V$ values. Fig. 10 also shows that $K_{TCU}$ has a linear change with respect to $\Delta V$ from $\Delta V=0.265V$ to $\Delta V=0.465V$ and is thus more easily controlled. In addition, it is found that $K_{TCU}$ does not change significantly with the tuning voltage Vtune within a $\Delta V$ range, which is desirable to circuit designers. As a result, if a wider tunable $K_{TCU}$ range is desired, then $K_{TCU}$ remains nearly constant within a small tuning voltage range. To the contrary, if the a circuit designer desires a constant $K_{TCU}$ over a wide tuning voltage range, only a small tunable $K_{TCU}$ range is obtained.

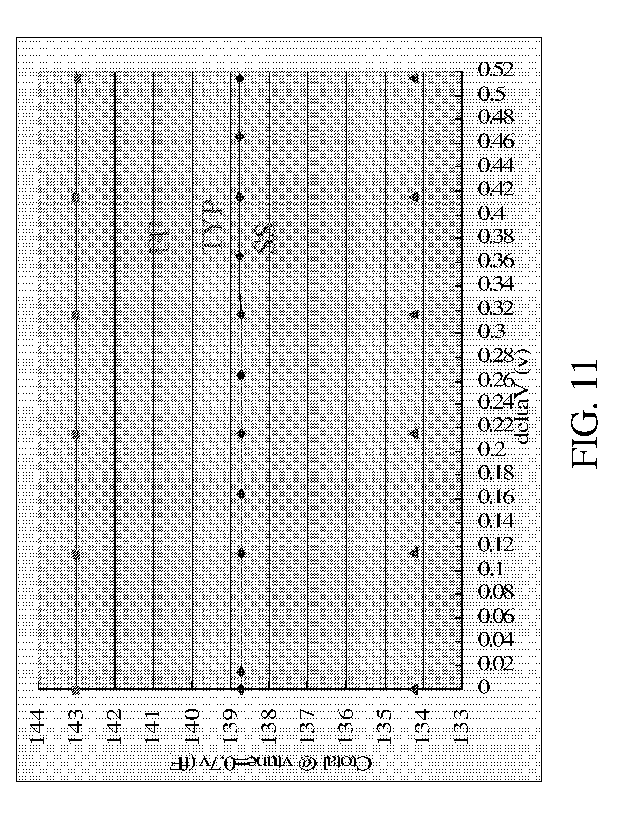

Fig. 11 is a diagram showing simulation results of an equivalent capacitance versus $\Delta V$ of the tunable capacitance unit in Fig. 4 for different process corners when the tuning voltage Vtune is 0.7V. In Fig. 11, square data points are data points of a process corner with fast NMOS and PMOS devices, diamond data points represent those of a process corner with typical NMOS and PMOS devices, and triangle data points represent those of a process corner with slow NMOS and PMOS devices. The equivalent capacitance of the tunable capacitance unit remains nearly constant over a very wide $\Delta V$ range. In addition, different process corners do not result in a significant change in the equivalent capacitance of the tunable capacitance unit. As a result, characteristics of the LC VCO are not significantly influenced by process variation.

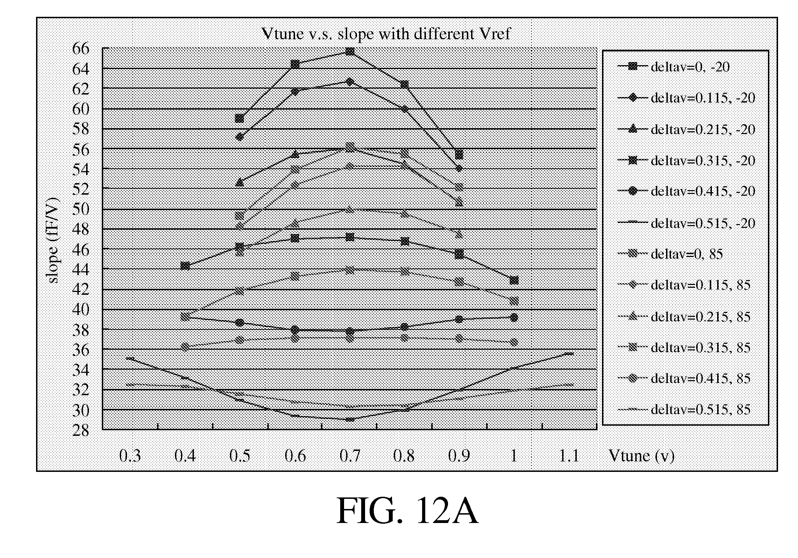

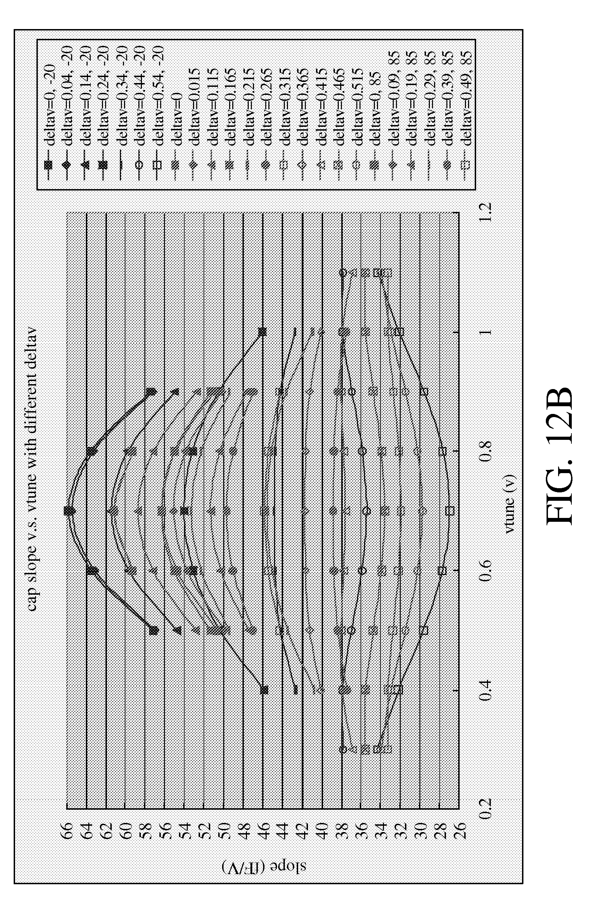

Fig. 12A is a diagram showing simulation results of $K_{TCU}$ versus a tuning voltage Vtune of the tunable capacitance unit in Fig. 4 at different temperatures (-20°C and 85°C). It is shown that temperature variation results in significant change in $K_{TCU}$, which is not desirable to circuit designers. To overcome such temperature effect, a temperature compensation mechanism is added to the tunable capacitance unit. Fig. 12B is another diagram showing simulation results of $K_{TCU}$ versus a tuning voltage Vtune of the tunable capacitance unit at different temperatures (-20°C, room temperature, and 85°C). Since temperature variation results in significant change in $K_{TCU}$, a temperature compensation mechanism is desirable such that characteristics of the LC VCO does not change significantly with temperature variation. If there is a temperature compensation circuit 740 in the tunable capacitance unit as shown in Fig. 8, a center voltage thereof is temperature compensated via temperature compensation of at least one of the fixed voltages. For example, Vref1=0.49V+$\Delta V$ and Vref2=0.49V-$\Delta V$ for high temperature condition, and Vref1=0.54V+$\Delta V$ and Vref2=0.54V-$\Delta V$ for low temperature condition. As a result, temperature variation may not result in significant change in $K_{TCU}$. In other words, temperature effect of the tunable capacitance unit is compensated.

A LC voltage controlled oscillator (VCO) with a tunable capacitance unit is disclosed. The disclosed LC VCO has a constant gain ($K_{VCO}$) within a wide frequency band and a bandwidth of a phase locked loop (PLL) circuit can be tuned by tuning a gain Kvco of the LC VCO. In addition, requirements for a compensation current of a charge pump circuit in the PLL circuit are relaxed and degradation of out-of-band phase noise due to high Kvco can also be avoided.

While the invention has been described by way of example and in terms of preferred embodiment, it is to be understood that the invention is not limited thereto. To the contrary, it is intended to cover various modifications and similar arrangements as would be apparent to those skilled in the art. Therefore, the scope of the appended claims should be accorded the broadest interpretation so as to encompass all such modifications and similar arrangements.

**Claims**

1. A tunable capacitance unit (300) coupled between a pair of circuit nodes, comprising:

   a tuning input (301) for receiving a tuning voltage (Vtune);
   a first pair of accumulation-mode MOS varactors (CV1, CV2) with source/drains thereof coupled to the tuning input (301);
   a first pair of blocking capacitors (C1, C2) coupled to a respective gate of the first pair of accumulation-mode MOS varactors (CV1, CV2) and to a respective one of the circuit nodes;
   a first pair of biasing resistors (R1, R2) coupled to a respective gate of the first pair of accumulation-mode MOS varactors (CV1, CV2) and to a first bias terminal receiving a first reference voltage (Vref1);
   a second pair of accumulation-mode MOS varactors (CV3, CV4) with source/drains thereof coupled to the tuning input (301);
   a second pair of blocking capacitors (C3, C4) coupled to a respective gate of the second pair of accumulation-mode MOS varactors (CV3, CV4) and to a respective one of the circuit nodes; and
a second pair of biasing resistors (R3, R4) coupled to a respective gate of the second pair of accumulation-mode MOS varactors (CV3, CV4) and to a second bias terminal receiving a second reference voltage (Vref2);

wherein the first and second reference voltages (Vref1, Vref2) are symmetrical to a predetermined voltage (Vnom).

2. The tunable capacitance unit (300) as claimed in claim 1, further comprising a voltage divider (710) comprising a plurality of resistors connected in series between a pair of fixed voltages and providing a plurality of reference voltages and first and second multiplexors (720, 730) each coupled between a respective one of the bias terminals and the voltage divider, wherein the predetermined voltage is a center voltage (Vcenter) of the voltage divider (710) and the first and second reference voltages (Vref1, Vref2) are selected from the reference voltages.

3. The tunable capacitance unit (300) as claimed in claim 2, further comprising a temperature compensation circuit (740) coupled to voltage divider (710) and providing at least one of the fixed voltages.

4. The tunable capacitance unit (300) as claimed in claim 1, further comprising a third pair of accumulation-mode MOS varactors with source/drains thereof coupled to the tuning input, a third pair of blocking capacitors coupled to a respective gate of the third pair of accumulation-mode MOS varactors and to a respective one of the circuit nodes, a third pair of biasing resistors coupled to a respective gate of the third pair of accumulation-mode MOS varactors and to a third bias terminal receiving a third reference voltage (630), a fourth pair of accumulation-mode MOS varactors with source/drains thereof coupled to the tuning input, a fourth pair of blocking capacitors coupled to a respective gate of the third pair of accumulation-mode MOS varactors and to a respective one of the circuit nodes, and a fourth pair of biasing resistors coupled to a respective gate of the fourth pair of accumulation-mode MOS varactors and to a fourth bias terminal receiving a fourth reference voltage (640), wherein the third and fourth reference voltages are symmetrical to the predetermined voltage.

5. A LC voltage controlled oscillator (100), comprising:

an LC tank circuit (110) comprising an inductor (L) and a tunable capacitance unit (300); and
a negative resistance circuit (120) coupled to the LC tank circuit (110);

wherein the tunable capacitance unit (300) comprises:

a tuning input (301) for receiving a tuning voltage (Vtune);
a first pair of accumulation-mode MOS varactors (CV1, CV2) with source/drains thereof coupled to the tuning input (301);
a first pair of blocking capacitors (C1, C2) coupled to a respective gate of the first pair of accumulation-mode MOS varactors (CV1, CV2) and to a respective one of the circuit nodes;
a first pair of biasing resistors (R1, R2) coupled to a respective gate of the first pair of accumulation-mode MOS varactors (CV1, CV2) and to a first bias terminal receiving a first reference voltage (Vref1);
a second pair of accumulation-mode MOS varactors (CV3, CV4) with source/drains thereof coupled to the tuning input (301);
a second pair of blocking capacitors (C3, C4) coupled to a respective gate of the second pair of accumulation-mode MOS varactors (CV3, CV4) and to a respective one of the circuit nodes; and
a second pair of biasing resistors (R3, R4) coupled to a respective gate of the second pair of accumulation-mode MOS varactors (Cv3, CV4) and to a second bias terminal receiving a second reference voltage (Vref2);

wherein the first and second reference voltages (Vref1, Vref2) are symmetrical to a predetermined voltage (Vnom).

6. The LC voltage controlled oscillator (100) as claimed in claim 5, wherein the negative resistance circuit (120) comprises a pair of transistors having first, second and third terminals, wherein the first terminals are cross-coupled to the second terminals thereof and the third terminals are coupled to a fixed voltage.

7. The LC voltage controlled oscillator (100) as claimed in claim 5, wherein the tunable capacitance unit (300) further comprises a voltage divider (710) comprising a plurality of resistors connected in series between a pair of fixed voltages and providing a plurality of reference voltages and first and second multiplexors (720, 730) each coupled between a respective one of the bias terminals and the voltage divider (710), wherein the predetermined voltage is a center voltage (Vcenter) of the voltage divider (710) and the first and second reference voltages (Vref1, Vref2) are selected from the reference voltages.

**8.** The LC voltage controlled oscillator (100) as claimed in claim 7, wherein the multiplexors (720, 730) are controlled according to an output frequency of the LC voltage controlled oscillator (100).

**9.** The LC voltage controlled oscillator (100) as claimed in claim 7, wherein the tunable capacitance unit (300) further comprises a temperature compensation circuit (740) coupled to voltage divider (710) and providing at least one of the fixed voltages.

**10.** The LC voltage controlled oscillator (100) as claimed in claim 5, wherein the tunable capacitance unit (300) further comprises a third pair of accumulation-mode MOS varactors with source/drains thereof coupled to the tuning input, a third pair of blocking capacitors coupled to a respective gate of the third pair of accumulation-mode MOS varactors and to a respective one of the circuit nodes, a third pair of biasing resistors coupled to a respective gate of the third pair of accumulation-mode MOS varactors and to a third bias terminal receiving a third reference voltage (630), a fourth pair of accumulation-mode MOS varactors with source/drains thereof coupled to the tuning input, a fourth pair of blocking capacitors coupled to a respective gate of the third pair of accumulation-mode MOS varactors and to a respective one of the circuit nodes, and a fourth pair of biasing resistors coupled to a respective gate of the fourth pair of accumulation-mode MOS varactors and to a fourth bias terminal receiving a fourth reference voltage (640), wherein the third and fourth reference voltages (Vref1, Vref2) are symmetrical to the predetermined voltage (Vnom).

**11.** The LC voltage controlled oscillator (100) as claimed in claim 5, wherein the LC tank circuit (110) further comprises a switch capacitor array (SCA) coupled to the inductor (L) and the tunable capacitance unit (300).

EP 1 988 628 A1

100

Vcc

120

Vtun

TCU    TCU

SCA

110

L

**FIG. 1A**

100

Vcc

120

TCU    TCU

Vtun

SCA

110

L

120

**FIG. 1B**

100

110

L

SCA

TCU    TCU

Vtun

120

**FIG. 1C**

FIG. 2

FIG. 3

FIG. 4

FIG. 5A

FIG. 5B

FIG. 5C

FIG. 6

300

Vref1

R1  R2

plus  mins

C1  CV1  CV2  C2

Vtune

C3  CV3  CV4  C4

R3  R4

Vref2  630

Tuning capacitance unit3

Vref3  640

Tuning capacitance unit4

Vref4

Tuning capacitance unitm

Vrefm

FIG. 7A

FIG. 7B

FIG. 8

FIG. 9

FIG. 10

EP 1 988 628 A1

FIG. 11

FIG. 12A

EP 1 988 628 A1

FIG. 12B

EP 1 988 628 A1

**EP 1 988 628 A1**

<table>
<tr><td colspan="2">European Patent<br>Office</td><td>**EUROPEAN SEARCH REPORT**</td><td>Application Number<br>EP 07 11 5764</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MIRA J ET AL: "Distributed MOS varactor biasing for VCO gain equalization in 0.13/spl mu/m CMOS technology" 6 June 2004 (2004-06-06), RADIO FREQUENCY INTEGRATED CIRCUITS (RFIC) SYMPOSIUM, 2004. DIGEST OF PAPERS. 2004 IEEE FORT WORTH, TX, USA JUNE 6-8, 2004, PISCATAWAY, NJ, USA,IEEE, PAGE(S) 131-134 , XP010713749 ISBN: 0-7803-8333-8 | 1,5,6 | INV.<br>H03B5/12 |
| Y | * the whole document *<br>----- | 2-4,7-11 | |
| Y | EP 1 505 721 A (SONY ERICSSON MOBILE COMM JAPA [JP]) 9 February 2005 (2005-02-09) * paragraph [0029]; figures 7,11 *<br>----- | 2-4,7-11 | |
| A | US 6 292 065 B1 (FRIEDMAN DANIEL JOSEPH [US] ET AL) 18 September 2001 (2001-09-18) * abstract; figure 3 *<br>----- | 1-11 | |
| A | EP 1 598 936 A (SONY ERICSSON MOBILE COMM JAPA [JP]) 23 November 2005 (2005-11-23) * the whole document *<br>----- | 1-11 | TECHNICAL FIELDS SEARCHED (IPC)<br><br>H03B |

The present search report has been drawn up for all claims

| Place of search | Date of completion of the search | Examiner |
|---|---|---|
| The Hague | 21 November 2007 | BEASLEY-SUFFOLK, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 11 5764

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2007

| Patent document cited in search report | | Publication date | Patent family member(s) | | Publication date |
|---|---|---|---|---|---|
| EP 1505721 | A | 09-02-2005 | JP 2005064691 A<br>US 2005030116 A1 | | 10-03-2005<br>10-02-2005 |
| US 6292065 | B1 | 18-09-2001 | NONE | | |
| EP 1598936 | A | 23-11-2005 | JP 2005333308 A<br>KR 20060048020 A<br>US 2005258914 A1 | | 02-12-2005<br>18-05-2006<br>24-11-2005 |

**REFERENCES CITED IN THE DESCRIPTION**

**Patent documents cited in the description**

- US 6995626 B